# FASCICULE DE BREVET EUROPEEN

(11) **EP 2 293 861 B1**
(45) Date de publication et mention de la délivrance du brevet: **25.01.2012**
(21) Numéro de dépôt: 09761935.7
(22) Date de dépôt: 12.06.2009
(51) Int. Cl.: B01D 45/16, B04C 5/18, B04C 5/185, B04C 5/187, B04C 5/22, B05D 7/22, C23C 16/04, C23C 16/511

(54) **MACHINE DE TRAITEMENT DE RÉCIPIENTS EN MATÉRIAU THERMOPLASTIQUE**
MASCHINE ZUR BEHANDLUNG VON BEHÄLTERN AUS THERMOPLASTISCHEM MATERIAL
MACHINE FOR PROCESSING VESSELS MADE OF THERMOPLASTIC MATERIAL

(30) Priorité: 13.06.2008 FR 0803275
(43) Date de publication de la demande: 16.03.2011
(73) Titulaire: Sidel Participations, 76930 Octeville sur Mer (FR)
(72) Inventeur: DUCLOS, Yves-Alban, F-76930 Octeville-sur-mer (FR)
(74) Mandataire: Cabinet Plasseraud
(86) Numéro de dépôt international: PCT/FR2009/051111
(87) Numéro de publication internationale: WO 2009/150384

(56) Documents cités:
- EP-A- 1 340 446
- WO-A-00/66804
- WO-A-99/17334
- CA-A1- 2 475 682
- FR-A- 1 547 355
- FR-A- 2 799 994
- JP-A- 2007 092 481
- US-A- 5 123 945
- US-A- 5 518 529

## Description

La présente invention concerne un perfectionnement aux machines de traitement des récipients en matériau thermoplastique, du genre bouteilles et, plus particulièrement, aux machines qui permettent de déposer sur la surface de ces récipients, un revêtement qui améliore, notamment, leur perméabilité.

Les bouteilles en PET, par exemple, sont particulièrement sensibles aux échanges gazeux et il est bien connu, comme décrit notamment dans le document WO00/66804, de traiter la paroi interne de ces bouteilles en déposant un revêtement qui fait office de barrière aux gaz. Ce revêtement réduit la perméabilité du PET, et il permet, par voie de conséquence, d'améliorer la durée de vie du contenu desdites bouteilles.

Ce traitement consiste à injecter dans le récipient, et sous vide, une petite quantité d'un gaz précurseur, du genre acétylène ou autres tel que de l'éthylène ou un mélange d'azote, d'oxygène et de HDMS, qui se décompose en un nuage de particules à l'état de plasma, lequel plasma étant généré par énergie micro-ondes et les particules de carbone qu'il contient se déposent d'elles-mêmes sur la paroi interne, par exemple, du récipient. Dès que le traitement est terminé, la pression atmosphérique est rétablie dans la zone de traitement et le récipient traité est évacué.

Les particules résiduelles de carbone, non déposées sur la paroi du récipient, forment une sorte de poussière et elles ont tendance à polluer les différents circuits de la machine avec une répercussion sur les instruments de mesure comme, par exemple, le capteur de pression présent, qui contrôle le vide, et le débitmètre régulateur de pression présent, qui contrôle le débit et la pression du gaz précurseur.

Le cycle des variations des pressions génère des mouvements au niveau des particules résiduelles de carbone, lesquels mouvements se situent dans la zone de traitement des récipients mais aussi dans les différents circuits qui sont connectés avec les instruments de mesure.

Les particules résiduelles font des allers-retours dans les circuits ; elles se déplacent vers les instruments de mesure au moment de la remise à la pression atmosphérique de la zone de traitement, et au moment de l'établissement du vide, préalablement à l'opération de traitement d'une nouvelle bouteille ; entre les deux mouvements, lesdites particules stagnent dans ladite zone de traitement et dans les différents circuits associés à cette zone.

Ces particules résiduelles encrassent les instruments de mesure et en particulier les filtres qui sont chargés de protéger ces instruments, et cet encrassement génère des variations de perte de charge dans les circuits qui relient ces instruments à la zone de traitement, ce qui provoque des dérives au niveau des valeurs indiquées et des erreurs.

Généralement, pour surmonter ce problème d'encrassement des filtres, un programme d'interventions est établi afin de procéder régulièrement à leur nettoyage, tous les quinze jours, par exemple ; ce programme tient compte bien sûr des quantités de récipients traités par la machine, mais il présente malgré tout un caractère empirique.

Par ailleurs ces interventions programmées de nettoyage sont effectuées avec un arrêt complet de la machine ; elles perturbent de façon importante la production de la machine.

La présente invention propose une solution originale à ce problème lié à la pollution des circuits et à l'encrassement des filtres de protection des instruments de mesure ; elle permet notamment de supprimer les programmes d'interventions qui ont comme inconvénient majeur d'arrêter la machine et la production des récipients et en particulier de bouteilles.

La présente invention propose un perfectionnement à ce type de machine qui réalise un traitement des bouteilles pour améliorer, notamment, leur perméabilité, par le biais d'un dépôt de carbone sur leur paroi interne, par exemple.

Ce perfectionnement selon l'invention consiste en un aménagement qui permet de protéger les instruments de mesure comme le capteur de pression et/ou le débitmètre régulateur de pression, face à cette pollution qui est engendrée par la circulation des particules résiduelles de carbone, tout en maîtrisant les problèmes de variations de perte de charge.

Cet aménagement permet d'éviter les problèmes classiques de dérives et d'erreurs de mesures ; il permet surtout de garantir la répétitivité, dans le temps, des mesures de pressions et des mesures de débit qui sont respectivement effectuées au niveau du capteur de pression qui contrôle le vide et au niveau du débitmètre régulateur de pression qui contrôle le débit et la pression d'introduction du gaz précurseur.

La machine selon l'invention comprend au moins un instrument de mesure, du genre capteur de pression, et/ou débitmètre avec régulation de la pression, qui est en communication, par un circuit approprié, avec la zone de traitement sous vide du récipient dans lequel se forment, par rayonnement micro-ondes, des particules développées sous forme de plasma à partir d'un gaz précurseur du genre acétylène introduit dans ledit récipient par un injecteur, lequel instrument de mesure est soumis à un cycle continu de variations de pressions allant - d'une valeur qui correspond à un quasi vide pour la phase de traitement des récipients, à - une valeur qui correspond à la pression atmosphérique pour la phase d'évacuation des récipients traités et d'introduction de nouveaux récipients,
laquelle machine comporte, sur le circuit reliant ladite zone de traitement du récipient et ledit instrument de mesure, un dispositif de filtration du type à perte de charge constante, constitué d'un cyclofiltre qui comprend une chambre de sédimentation disposée entre un conduit tangentiel de centrifugation et un conduit de piquage, lequel cyclofiltre est connecté, - par son conduit tangentiel de centrifugation, au tronçon du circuit qui s'étend jusqu'à la zone où s'effectue le traitement desdits récipients et, - par son conduit de piquage, au tronçon du circuit qui s'étend jusqu'à l'instrument de mesure de façon à permettre, d'une part, de stopper automatiquement les particules résiduelles pendant le passage du flux montant dans ledit cyclofiltre et de retenir temporairement ces particules résiduelles dans ladite chambre de sédimentation de ce dernier et, d'autre part, de faire nettoyer automatiquement ladite chambre de sédimentation au moyen du reflux dont le souffle est tel qu'il permet d'agiter lesdites particules résiduelles dans ladite chambre de sédimentation et de les évacuer vers l'extérieur.

Sur une machine de traitement de récipients qui fonctionne à grande cadence, les flux et reflux à travers le cyclofiltre permettent d'éviter une saturation de la chambre de sédimentation ; elle reste propre, garantissant un fonctionnement sans maintenance.

Toujours selon l'invention, la machine comprend un circuit dont le tronçon situé en aval du cyclofiltre, c'est-à-dire entre ce dernier et l'instrument de mesure, a une capacité d'accueil de gaz et autre, en terme de volume, qui est suffisante pour que s'établisse un reflux significatif dans la chambre de sédimentation dudit cyclofiltre afin d'agiter et d'évacuer automatiquement les particules résiduelles retenues dans ladite chambre.

Selon une autre disposition de l'invention, la machine comprend un circuit dont le tronçon situé en amont du cyclofiltre, entre ce dernier et la zone de traitement, a une capacité d'accueil de gaz, en terme de volume, qui est inférieure à celle du tronçon aval pour permettre un transfert total de la quantité de particules stockées au niveau dudit cyclofiltre vers ladite zone de traitement en passant par ledit tronçon situé en amont.

Toujours selon l'invention, la machine comporte un instrument de mesure constitué d'un capteur de pression qui est relié, par un circuit, à la tubulure servant, d'une part, à établir le vide dans le récipient et, d'autre part, à rétablir la pression atmosphérique après le traitement du récipient, lequel circuit comporte, sur sa longueur, un cyclofiltre.

Selon une autre disposition de l'invention, la machine comporte un instrument de mesure constitué d'un débitmètre avec régulation de pression, lequel débitmètre alimente, par un circuit approprié, l'injecteur qui introduit le gaz précurseur dans le récipient à traiter, lequel circuit comporte, sur sa longueur, un cyclofiltre.

Toujours selon l'invention, la machine comporte au moins un cyclofiltre qui comprend :
- un corps supérieur de forme cylindrique à axe vertical,
- un conduit disposé tangentiellement sur la partie supérieure dudit corps cylindrique et centré sur un axe perpendiculaire à l'axe de ce dernier, lequel conduit est en communication avec la zone de traitement des récipients et permet de réaliser la centrifugation des particules résiduelles,
- une chambre de sédimentation, en forme de cône renversé, disposée sous ledit corps cylindrique pour recueillir lesdites particules résiduelles,
- un conduit de piquage qui plonge au centre dudit corps cylindrique, lequel conduit de piquage se prolonge au-dessus dudit corps en direction de l'instrument de mesure correspondant.

Selon une autre disposition de l'invention, la machine comprend un cyclofiltre dont le conduit de piquage s'étend dans le corps cylindrique sur une hauteur qui est de l'ordre des 2/3 du diamètre du corps cylindrique.

Toujours selon l'invention, la machine comprend un cyclofiltre dont la partie conique de la chambre de sédimentation s'étend sur une hauteur qui correspond à celle de la paroi cylindrique active du corps et au diamètre de ce dernier.

L'invention concerne également un procédé de filtration qui permet de protéger au moins un instrument de mesure pour contrôler les paramètres du processus de traitement des récipients mis en oeuvre dans une machine qui réalise, dans une zone de traitement, le dépôt d'un revêtement de particules carbone sur la paroi desdits récipients par formation d'un plasma à partir d'un gaz précurseur, lequel instrument de mesure est soumis à un cycle continu de variations de pressions allant d'une valeur qui correspond à un vide, pendant la phase de traitement du récipient, jusqu'à une valeur égale à la pression atmosphérique, lors de l'évacuation du récipient traité et de la mise en place d'un nouveau récipient, lequel procédé consiste :
- à stopper les particules résiduelles, entre la zone de traitement et ledit instrument, au moyen d'une centrifugation desdites particules par effet cyclonique dans un dispositif approprié du genre cyclofiltre, laquelle centrifugation est activée et mise en oeuvre par le flux qui est en mouvement lors du rétablissement de la pression atmosphérique,
- à stocker in situ, et de façon temporaire, lesdites particules ainsi stoppées, dans une chambre de sédimentation,
- à agiter lesdites particules résiduelles qui sont stockées temporairement dans ladite chambre de sédimentation, au moyen du souffle provoqué par le reflux qui traverse ledit cyclofiltre, lors de la mise sous vide de la zone chargée de particules, lequel souffle étant prévu suffisant, en force et en quantité, pour entraîner lesdites particules résiduelles fraîchement stockées et pour les évacuer.

Mais l'invention sera encore détaillée à l'aide de la description suivante et des dessins annexés, donnés à titre indicatif, et dans lesquels :
- la figure 1 est une vue schématique partielle d'une machine de traitement de la surface interne d'une bouteille, laquelle vue montre l'installation de protection de deux instruments de mesure connectés à la zone où s'effectue le traitement et dans laquelle circule le gaz chargé de particules,
- la figure 2 est une coupe verticale schématique du dispositif de filtration, en forme de cyclofiltre, intégré à l'installation de protection propre à chaque instrument de mesure,
- la figure 3 est une coupe selon 3-3 de la figure 2.

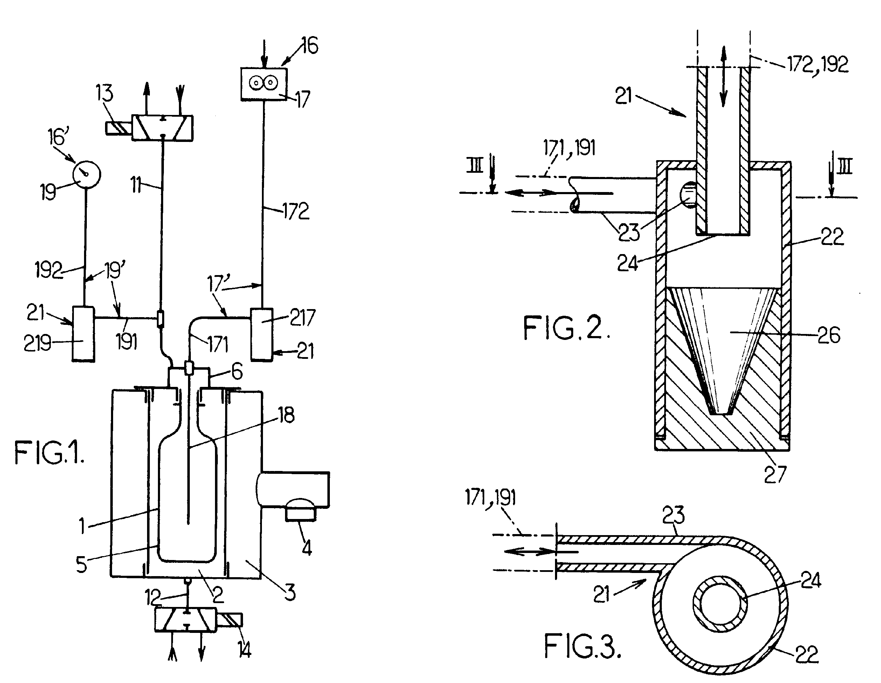

La machine de traitement, représentée figure 1, permet de déposer un revêtement sur la surface interne d'une bouteille (1), par exemple.

Cette bouteille (1) est disposée dans une enceinte (2) qui est étanche, laquelle enceinte (2) est elle-même disposée dans une chambre (3) qui fait office de cavité micro-ondes. Un générateur (4) est associé à la chambre (3) pour délivrer un rayonnement avec une fréquence appropriée micro-ondes.

La paroi (5) qui délimite l'enceinte (2) est constituée d'un matériau perméable au rayonnement, comme du verre ou du quartz.

La bouteille (1) est fixée de façon étanche à une sorte de couvercle (6) qui peut, par exemple, assurer en même temps l'étanchéité de l'enceinte (2).

Le traitement qui consiste à déposer un revêtement sur la surface interne de la bouteille (1) s'effectue sous vide, à une pression qui est très faible, aussi bien dans la bouteille qu'à l'extérieur de cette dernière, c'est-à-dire dans l'enceinte (2).

Le vide est réalisé dans la bouteille (1) avec une pression de l'ordre de 0,05 mbar au moyen d'une tubulure (11) qui est connectée, par exemple, sur le couvercle (6).

De même, l'enceinte (2) comporte une tubulure (12) qui permet de réaliser un vide relatif, légèrement moins important que celui de la bouteille (1) ; ce vide est, par exemple, de l'ordre 50 mbar.

La tubulure (11) comporte une électrovanne (13) du type trois voies, pour réaliser la mise à l'atmosphère, le vide ou maintenir le vide durant l'opération de traitement du récipient.

La tubulure (12) comporte, de la même façon, une électrovanne (14), du type trois voies, pour réaliser la mise à l'atmosphère, le vide ou maintenir le vide durant l'opération de traitement, dans l'enceinte (2).

L'acheminement du gaz précurseur dans la bouteille (1) s'effectue au moyen d'un appareil qui constitue un instrument (16) de mesure de débit et de pression pour le gaz précurseur. Cet instrument (16) est constitué d'un débitmètre (17) qui fait également office de régulateur de pression. L'acheminement du gaz précurseur s'effectue par l'intermédiaire d'un circuit (17') approprié et ledit gaz précurseur est introduit dans la bouteille (1) au moyen d'un injecteur (18). Cet injecteur (18) s'étend dans la bouteille (1) à partir du couvercle (6) ; il prolonge le circuit (17').

Lorsque le vide est établi par la tubulure (11) dans la bouteille (1) et, par voie de conséquence, dans le circuit (17'), le gaz précurseur est introduit, sous le contrôle du débitmètre (17), dans la zone constituée par ledit circuit (17'), puis dans l'injecteur (18) et la bouteille (1), sans modifier de façon significative la pression qui règne dans ladite bouteille (1).

La pression qui règne dans l'ensemble de la zone contenant le gaz précurseur, c'est-à-dire dans la bouteille (1), dans la tubulure (11) et dans le circuit (17'), est contrôlée au moyen d'un autre instrument (16') de mesure constitué d'un capteur (19) de pression. Ce capteur (19) de pression est, par exemple, relié à la tubulure (11) au moyen d'un circuit (19') et ce circuit (19') est bien évidemment soumis lui aussi à ces cycles de variations de pressions.

Après l'opération de traitement des bouteilles, chaque circuit (17', 19') voit circuler un flux et un reflux de gaz chargé de particules résiduelles, en suspension dans ce gaz, lesquelles particules résiduelles constituent une sorte de poussière polluante qui peut perturber les instruments (16, 16') de mesure, c'est-à-dire le débitmètre (17) et le capteur (19) de pression.

Pour protéger ce débitmètre (17) et ce capteur (19) de pression, des moyens de filtration sont installés sur la longueur des circuits (17') et (19') respectivement et en particulier des moyens qui stoppent les particules résiduelles véhiculées par le courant qui s'installe sous la forme d'un flux et d'un reflux au moment de la remise à la pression atmosphérique après l'opération de traitement et au moment de la mise sous vide pour réaliser l'opération de traitement de la surface interne de la bouteille (1).

Ces moyens de filtration peuvent être avantageusement constitués, pour chaque circuit (17') et (19'), d'un filtre du type cyclonique qui permet d'effectuer une filtration efficace par centrifugation desdites particules.

Cette filtration s'effectue avantageusement sans aucune variation de perte de charge dans le temps; la perte de charge dans ce genre de filtre cyclonique présente l'avantage d'être constante.

Ces filtres, appelés dans la suite du texte cyclofiltres (21), permettent, par simple centrifugation, de stopper les particules qui circulent dans chacun des circuits reliant les instruments (16, 16') de mesure à la zone de traitement. Ainsi, on trouve un cyclofiltre (217) installé sur la longueur du circuit (17') et un cyclofiltre (219) installé sur la longueur du circuit (19'), lesquels circuits (17') et (19') correspondants aux instruments (16, 16') de mesure, respectivement.

Cette centrifugation est possible du fait de la vitesse de circulation des particules portées par le flux dans les circuits (17') et (19'). Ce fonctionnement normal du cyclofiltre s'effectue après le traitement de la bouteille (1), c'est-à-dire après la rupture du vide, lors du rétablissement de la pression atmosphérique dans la bouteille (1), notamment. Cette remise à la pression atmosphérique de la zone de traitement s'effectue par l'ouverture de l'électrovanne (13) en laissant l'air pénétrer dans le récipient (1), au niveau du couvercle (6), amené par la tubulure (11).

Au moment de cette remise à la pression atmosphérique, un courant s'établit dans les différents circuits comme les circuits (17') et (19'), sous la forme d'un flux chargé de particules résiduelles de carbone. Ce courant se produit pendant un temps très court et les circuits en question restent ensuite à la pression atmosphérique, le temps d'évacuer la bouteille (1) qui vient d'être traitée et le temps de placer une nouvelle bouteille à traiter.

Dès qu'un nouveau récipient (1)) est en place, le vide est réalisé dans la bouteille (1) et, simultanément, dans les différents circuits (17') et (19'), par l'intermédiaire de la tubulure (11), et, pour être précis, dans l'enceinte (2), par l'intermédiaire de la tubulure (12).

Cette instauration du vide provoque une aspiration des gaz et des particules résiduelles dans la zone de traitement et elle provoque, au niveau des cyclofiltres (21), un contre-courant, ou reflux, qui a pour effet, comme expliqué ci-après, d'agiter les particules qui ont été préalablement centrifugées et stoppées au niveau desdits cyclofiltres.

Les cyclofiltres (21), repérés (217) pour celui qui est installé sur le circuit (17') et repérés (219) pour celui qui est installé sur le circuit (19'), réalisent une division de chacun desdits circuits (17') et (19'), en deux tronçons.

Le circuit (17') qui s'étend entre l'injecteur (18) et le débitmètre (17) comprend un tronçon (171) aval, situé entre ledit injecteur (18) et le cyclofiltre (217), ainsi qu'un tronçon (172) amont situé entre ce dernier et ledit débitmètre (17).

De la même façon, le circuit (19') qui va de la tubulure (11) vers le capteur (19) de pression comprend un tronçon (191) amont, qui s'étend entre ladite tubulure (11) et le cyclofiltre (219), ainsi qu'un tronçon (192) aval entre ce dernier et ledit capteur (19) de pression.

Chaque cyclofiltre (21), comme représenté figure 2, comprend un corps (22) de forme cylindrique, à axe vertical, dont le volume est adapté à l'installation, de l'ordre de quelques cm³.

Ce corps (22) comporte un conduit (23) qui est greffé tangentiellement à sa partie supérieure. Comme représenté figure 3, ce conduit (23) est greffé tangentiellement sur le corps (22) pour réaliser une centrifugation des particules résiduelles lorsqu'elles pénètrent dans ledit corps (22). Ce conduit (23) est également centré sur un axe qui est perpendiculaire à l'axe du corps (22) et il est connecté, selon le cas, au tronçon (171) du circuit (17') et au tronçon (191) du circuit (19').

Le corps (22) comporte également un conduit (24) de piquage qui plonge verticalement au centre dudit corps (22) et qui s'étend en saillie, dans ce dernier, sur une hauteur de l'ordre des 2/3 du diamètre dudit corps.

Ce conduit (24) de piquage est connecté, selon le cas, au tronçon (172) du circuit (17') et au tronçon (192) du circuit (19').

La hauteur de la paroi cylindrique active du corps (22), sur laquelle sont centrifugées les particules contenues dans le gaz, est du même ordre que le diamètre dudit corps (22).

La partie inférieure du cyclofiltre (21) est constituée d'une chambre (26) de sédimentation. Cette chambre (26), en forme de cône renversé, pointé vers le bas, est façonnée dans un bloc (27) cylindrique qui se loge dans la partie inférieure du corps (22) et ce bloc est fixé à ce dernier par tout moyen approprié.

La hauteur de la chambre (26) de sédimentation est du même ordre de grandeur que la hauteur de la paroi cylindrique active du corps (22).

Les cyclofiltres (21) fonctionnent de façon cyclique, avec la même fréquence que la machine de traitement des récipients (1). Leur fonctionnement passe par plusieurs états qui sont une succession de circulation de flux de gaz entrecoupés de périodes de repos.

Lorsque les cyclofiltres (21) fonctionnent normalement, pour stopper les particules par centrifugation, le conduit (24) de piquage fait office de sortie. Toutefois cette sortie est sans issue et elle voit passer du gaz jusqu'au moment où il y a équilibre des pressions dans les circuits (17') et (19') correspondants et dans toute la zone de traitement. A l'inverse, ce conduit (24) fait office de conduit d'entrée lorsque les cyclofiltres fonctionnent à contre courant et que les particules résiduelles, situées dans les chambres de sédimentation correspondantes, s'agitent sous l'effet du reflux et quittent lesdites chambres (26).

Les cyclofiltres (21) fonctionnent de façon classique, pour stopper les particules en suspension dans le gaz, pendant la phase du cycle de traitement de la bouteille (1) qui correspond à la phase de rétablissement de la pression atmosphérique dans ladite bouteille (1), c'est-à-dire après l'opération de dépose du revêtement sur la paroi de ladite bouteille.

De part et d'autre de cette phase qui correspond à la séparation cyclonique, le cyclofiltre (21) est en repos. Il est de nouveau traversé par le gaz mais à contre courant, par le reflux, pendant la phase de mise sous vide de la bouteille (1) et des différents circuits. Pendant ce reflux, les particules qui se sont déposées dans la chambre de sédimentation (26) sont agitées par le contre courant de gaz et elles sont entraînées par ce dernier de sorte que ladite chambre (26) de sédimentation se vide automatiquement ; elle est auto-nettoyante.

Chaque cyclofiltre (21) retient les particules qui sont en suspension dans le gaz lorsque ce dernier circule dans le circuit (17', 19') correspondant en allant de la zone qui est chargée avec ces particules, c'est-à-dire - la bouteille (1), - la tubulure (11) et - l'injecteur (18), vers l'appareil (16, 16') correspondant, et ceci au moment de la remise à la pression atmosphérique de ladite zone. Pendant cette phase particulière du cycle de variations de pressions, les particules sont centrifugées et se déposent dans la chambre (26) de sédimentation de chaque cyclofiltre (21). Ce dépôt dans la chambre (26) de sédimentation présente un caractère temporaire.

En effet, comme expliqué précédemment, au moment de l'application du vide dans la zone en question, chaque cyclofiltre (21) est traversé par le reflux du gaz et le souffle généré notamment par ce reflux est dirigé, par le conduit (24) de piquage, sur les particules qui sont dans la chambre (26) de sédimentation correspondante, lesquelles particules sont agitées par ce reflux et elles sont entraînées par l'aspiration venant de la tubulure (11).

Pour le circuit (17'), l'injection du gaz précurseur à travers le débitmètre (17), vers la bouteille (1), accroît cet auto-nettoyage dudit circuit (17') et en particulier le nettoyage de l'injecteur (18).

Pour obtenir un reflux suffisant dans le circuit (19'), à travers le cyclofiltre (219) correspondant, et en particulier un reflux capable de nettoyer la chambre (26) de sédimentation, le tronçon (192) aval peut avoir une capacité, en volume de gaz, relativement conséquente, supérieure à celle du tronçon (191) amont. Avec cet aménagement, la quantité de particules stoppées lors du passage du flux de gaz dans le cyclofiltre (219) est totalement reprise par le reflux et elle est ramenée dans la tubulure (11); on obtient ainsi un auto-nettoyage du cyclofiltre (219).

A titre d'exemple, selon un mode de réalisation possible de l'invention, le volume disponible dans le tronçon (192) du circuit (19'), entre le capteur (19) de pression et le cyclofitre (219), est de l'ordre de 18 cm³. Le temps d'application du reflux, c'est-à-dire le temps nécessaire pour l'établissement du vide dans ce circuit (19'), notamment, est de l'ordre de 50 ms avec un débit maximum instantané de l'ordre de 88 Ncm³/s. Le débit maximum instantané du flux, lors de la remontée à la pression atmosphérique, est de l'ordre de 500 Ncm³/s.

D'une manière générale, le temps d'application du flux dans l'installation, pour la remise à la pression atmosphérique, est de l'ordre de 100 ms. La vitesse instantanée minimale du flux est de l'ordre de 166 mbar par 10 ms et la vitesse instantanée minimale du reflux, lors de l'établissement du vide, est de l'ordre de -100 mbar par 10 ms.

Pour le débitmètre (17), les données sont différentes et, d'une certaine manière, le fonctionnement du cyclofiltre (217) associé est également différent de celui qui est associé au capteur (19) de pression.

En effet, après l'établissement du vide, qui correspond, d'une manière générale au reflux, le circuit (17') du débitmètre est le siège d'une circulation contrôlée de gaz, en l'occurrence le gaz précurseur. Lors du reflux, la chambre (26) de sédimentation du cyclofiltre (217) est balayée à grande vitesse comme celle du cyclofiltre (219) et elle continue à être balayée, mais à vitesse plus réduite ensuite, par le gaz précurseur qui est introduit dans la zone de traitement et en particulier dans la bouteille (1).

Le volume du tronçon (172) du circuit (17') situé entre le cyclofiltre (217) et le débitmètre (17) est de l'ordre de 3 cm³. Ce volume est suffisant pour réaliser une agitation importante des particules résiduelles qui se situent dans la chambre (26) de sédimentation lors de l'établissement du vide, lesquelles particules sont ensuite entraînées par la circulation du gaz précurseur qui traverse ladite chambre (26) et tout le cyclofiltre (217).

Ainsi, pour le débitmètre (17), le temps total d'application du reflux est de l'ordre de 2 s avec un débit qui varie de 15 à 3 Ncm³/s ; le débit maximum instantané de ce reflux est de l'ordre de 15 Ncm³/s.

Toujours pour le débitmètre (17), le débit maximum instantané de flux, lors de la remontée à la pression atmosphérique, est de l'ordre de 100 Ncm³/s.

## Revendications

1. Procédé de filtration qui permet de protéger au moins un instrument (16, 16') de mesure et de contrôle des paramètres du processus de traitement des récipients mis en oeuvre dans une machine qui réalise, dans une zone de traitement, le dépôt d'un revêtement de particules sur la paroi desdits récipients par formation d'un plasma à partir d'un gaz précurseur, lequel instrument de mesure est soumis à un cycle continu de variations de pressions allant d'une valeur qui correspond à un quasi vide, pendant la phase de traitement du récipient, jusqu'à une valeur qui correspond à la pression atmosphérique, lors de l'évacuation du récipient traité et de la mise en place d'un nouveau récipient, lequel procédé consiste :
- à stopper les particules résiduelles, entre ladite zone de traitement et ledit instrument, au moyen d'une centrifugation desdites particules par effet cyclonique dans un dispositif approprié du genre cyclofiltre (21), laquelle centrifugation est activée et mise en oeuvre par le flux qui est en mouvement lors du rétablissement de la pression atmosphérique,
- à stocker in situ, et de façon temporaire, lesdites particules ainsi stoppées, dans une chambre (26) de sédimentation dudit cyclofiltre (21),
- à agiter lesdites particules résiduelles qui sont stockées temporairement dans ladite chambre (26) de sédimentation, au moyen du souffle provoqué par le reflux qui traverse ledit cyclofiltre (21), lors de la mise sous vide de la zone chargée de particules, lequel souffle étant prévu suffisant, en force et en quantité, pour entraîner lesdites particules résiduelles fraîchement stockées et pour les évacuer.

2. Procédé de filtration selon la revendication 1, **caractérisé en ce qu'**il consiste à établir, dans l'un au moins des circuits et, notamment, le circuit (19') du capteur (19) de pression, un débit instantané de flux, lors de la remontée en pression jusqu'à la pression atmosphérique, de l'ordre de 500 Ncm³/s et un débit instantané de reflux, lors de l'établissement du vide, de l'ordre de 88 Ncm³/s.

3. Machine pour la mise en oeuvre du procédé de filtration selon l'une quelconque des revendications 1 ou 2, laquelle machine étant aménagée pour réaliser le traitement de récipients par dépôt sous vide d'un revêtement de particules sur la paroi de chaque récipient au moyen d'un procédé de formation d'un plasma à partir d'un gaz précurseur, et elle comprend au moins un instrument (16, 16') de mesure du genre capteur (19) de pression et/ou débitmètre (17) avec régulation de la pression, lequel au moins un instrument est en communication, par un circuit approprié, avec la zone de traitement dudit récipient dans laquelle se forment, par rayonnement micro-ondes, des particules développées sous forme de plasma à partir dudit gaz précurseur du genre acétylène introduit dans ledit récipient par un injecteur (18),
**caractérisée en ce qu'**elle comporte, sur le circuit reliant ladite zone de traitement du récipient et ledit au moins un instrument de mesure, un dispositif de filtration du type à perte de charge constante, constitué d'un cyclofiltre (21) qui comprend une chambre (26) de sédimentation disposée entre un conduit (23) tangentiel de centrifugation et un conduit (24) de piquage, lequel cyclofiltre est connecté, - par son conduit (23) tangentiel de centrifugation, au tronçon du circuit qui s'étend jusqu'à la zone où s'effectue le traitement desdits récipients et, - par son conduit (24) de piquage, au tronçon du circuit qui s'étend jusqu'à l'instrument de mesure.

4. Machine selon la revendication 3, **caractérisée en ce qu'**elle comprend un circuit dont le tronçon situé en aval du cyclofiltre (21), c'est-à-dire entre ce dernier et l'instrument de mesure, a une capacité d'accueil de gaz et autre, en terme de volume, qui est suffisante pour que s'établisse un reflux significatif dans la chambre de sédimentation dudit cyclofiltre afin d'agiter et d'évacuer automatiquement les particules résiduelles retenues dans ladite chambre.

5. Machine selon la revendication 3, **caractérisée en ce qu'**elle comprend un circuit dont le tronçon situé en amont du cyclofiltre, entre ce dernier et la zone de traitement, a une capacité d'accueil de gaz, en terme de volume, qui est inférieure à celle du tronçon aval pour permettre un transfert total de la quantité de particules stockées au niveau dudit cyclofiltre vers ladite zone de traitement en passant par ledit tronçon situé en amont.

6. Machine selon la revendication 3, **caractérisée en ce qu'**elle comporte un instrument (16') de mesure constitué d'un capteur (19) de pression qui est relié, par un circuit (19'), à la tubulure (11) servant, d'une part, à établir le vide dans le récipient et, d'autre part, à rétablir la pression atmosphérique après le traitement du récipient, lequel circuit (19') comporte, sur sa longueur, un cyclofiltre (21).

7. Machine selon la revendication 3, **caractérisée en ce qu'**elle comporte un instrument (16) de mesure constitué d'un débitmètre (17) avec régulation de pression, lequel débitmètre (17) alimente, par un circuit (17') approprié, l'injecteur (18) qui introduit le gaz précurseur dans le récipient à traiter, lequel circuit (17') comporte, sur sa longueur, un cyclofiltre (21).

8. Machine selon la revendication 3, **caractérisée en ce qu'**elle comporte au moins un cyclofiltre (21) qui comprend :
- un corps (22) supérieur de forme cylindrique à axe vertical,
- un conduit (23) disposé tangentiellement sur la partie supérieure dudit corps cylindrique et centré sur un axe perpendiculaire à l'axe de ce dernier, lequel conduit (23) est en communication avec la zone de traitement des récipients et permet de réaliser la centrifugation des particules résiduelles,
- une chambre (26) de sédimentation, en forme de cône renversé, disposée sous ledit corps (22) cylindrique pour recueillir lesdites particules résiduelles,
- un conduit (24) de piquage qui plonge au centre dudit corps (22) cylindrique, lequel conduit (24) de piquage se prolonge au-dessus dudit corps (22) en direction de l'instrument (16, 16') de mesure correspondant.

9. Machine selon la revendication 8, **caractérisée en ce qu'**elle comprend un cyclofiltre (21) dont le conduit (24) de piquage s'étend dans le corps (22) cylindrique sur une hauteur qui est de l'ordre des 2/3 du diamètre dudit corps (22) cylindrique.

10. Machine selon la revendication 8, **caractérisée en ce qu'**elle comprend un cyclofiltre (21) dont la partie conique de la chambre (26) de sédimentation s'étend sur une hauteur qui correspond à celle de la paroi cylindrique active du corps (22) cylindrique et au diamètre de ce dernier.

## Claims

1. Method of filtration enabling at least one instrument (16, 16') for measuring and controlling parameters to be protected for a process of treating receptacles implemented in a machine which deposits a coating of particles on the wall of said receptacles in a treatment zone by forming a plasma from a precursor gas, which measuring instrument is subjected to a continuous cycle of pressure variations ranging from a value corresponding to a quasi-vacuum during the phase of treating the receptacle to a value corresponding to atmospheric pressure during the process of removing the treated receptacle and positioning a new receptacle, which process involves:
- stopping the residual particles between said treatment zone and said instrument by a process of centrifugation of said particles by a cyclonic effect in an appropriate device of the cyclo-filter (21) type, which centrifugation process is activated and implemented by the flux which is in motion as atmospheric pressure is being re-established,
- storing, in situ and on a temporary basis, said particles thus stopped in a settlement chamber (26) of said cyclo-filter (21),
- agitating said residual particles temporarily stored in said settlement chamber (26) by means of the blast caused by the reflux as it passes through said cyclo-filter (21) whilst the zone charged with particles is being placed under vacuum, which blast is such that it is sufficient in terms of force and quantity to entrain said freshly stored residual particles and to evacuate them.

2. Filtration method as claimed in claim 1, **characterised in that** it comprises establishing in at least one of the circuits, and in particular circuit (19') of the pressure sensor (19), an instantaneous flux flow rate in the order of 500 Ncm³/s whilst the pressure is being raised to atmospheric pressure and an instantaneous reflux rate in the order of 88 Ncm³/s whilst the vacuum is being established.

3. Machine for implementing the filtration method as claimed in any one of claims 1 or 2, which machine is configured to implement the treatment of receptacles by depositing a coating of particles on the wall of each receptacle under vacuum by means of a process of forming a plasma from a precursor gas, and it has at least one measuring instrument (16, 16') of the pressure sensor (19) and/or flow meter (17) with pressure regulation type, which at least one instrument communicates via an appropriate circuit with the zone in which said receptacle is treated, where particles are developed in the form of plasma by microwave radiation from said precursor gas of the acetylene type introduced into said receptacle by an injector (18), **characterised in that** it has, on the circuit linking said zone for treating the receptacle and said at least one measuring instrument, a filtration device of the type having a constant load-loss, comprising a cyclo-filter (21) with a settlement chamber (26) disposed between a tangential centrifugation duct (23) and a tapping duct (24), which cyclo-filter is connected via its tangential centrifugation duct (23) to the section of the circuit extending to a zone where the treatment of said receptacles takes place and by its tapping duct (24) to the section of the circuit extending to the measuring instrument.

4. Machine as claimed in claim 3, **characterised in that** it comprises a circuit whose section disposed downstream of the cyclo-filter (21), i.e. between the latter and the measuring instrument, has a capacity to accommodate gas and other things, in terms of volume, which is sufficient for a reflux to be established in the settlement chamber of said cyclo-filter strong enough to agitate and remove the residual particles retained from said chamber automatically.

5. Machine as claimed in claim 3, **characterised in that** it comprises a circuit whose section disposed upstream of the cyclo-filter between the latter and the treatment zone has a capacity to accommodate gas, in terms of volume, which is less than that of the downstream section to enable the quantity of particles stored at the level of said cyclo-filter to be totally transferred to said treatment zone passing via said section disposed upstream.

6. Machine as claimed in claim 3, **characterised in that** it has a measuring instrument (16') comprising a pressure sensor (19) which is connected via a circuit (19') to the ducting (11) used on the one hand to establish the vacuum in the receptacle and on the other hand to restore atmospheric pressure after treatment of the receptacle, which circuit (19') comprises a cyclo-filter (21) along its length.

7. Machine as claimed in claim 3, **characterised in that** it has a measuring instrument (16) comprising a flow meter (17) with pressure regulation, which flow meter (17) supplies via an appropriate circuit (17') the injector (18) which introduces the precursor gas into the receptacle to be treated, which circuit (17') comprises a cyclo-filter (21) along its length.

8. Machine as claimed in claim 3, **characterised in that** it has at least one cyclo-filter (21) which comprises:
- a cylindrically shaped top body (22) with a vertical axis,
- a tangentially disposed duct (23) on the top part of said cylindrical body and centred on an axis perpendicular to the axis of the latter, which duct (23) communicates with the zone where the receptacles are treated and enables the residual particles to be centrifuged,
- a settlement chamber (26) in the shape of an upturned cone, disposed underneath said cylindrical body (22) to collect said residual particles,
- a tapping duct (24) which extends down to the centre of said cylindrical body (22), which tapping duct (24) is extended above said body (22) in the direction of the corresponding measuring instrument (16, 16').

9. Machine as claimed in claim 8, **characterised in that** it has a cyclo-filter (21), the tapping duct (24) of which extends into the cylindrical body (22) at a height in the order of 2/3 of the diameter of said cylindrical body (22).

10. Machine as claimed in claim 8, **characterised in that** it has a cyclo-filter (21), of which the conical pat of the settlement chamber (26) extends at a height corresponding to that of the active cylindrical wall of the cylindrical body (22) and to the diameter of the latter.

## Patentansprüche

1. Filterverfahren, das ermöglicht, mindestens eine Mess- und Kontrollvorrichtung (16, 16') für Parameter eines Behälterbehandlungsprozesses zu schützen und in einer Maschine verwendet wird, die in einem Behandlungsbereich die Ablagerung einer Partikelbeschichtung auf der Wand dieser Behälter über Bildung eines Plasmas aus einem Vorläufergas ausführt, wobei die Messvorrichtung einem fortlaufenden Zyklus von Druckänderungen unterworfen ist, ausgehend von einem Wert während der Behandlungsdauer der Behälter, der nahezu einem Vakuum entspricht, bis zu einem Wert bei der Entnahme des behandelten Behälters und dem Platzieren eines neuen Behälters, der dem Atmosphärendruck entspricht, wobei das Verfahren aufweist:
- Aufhalten der Restpartikel zwischen dem Behandlungsbereich und dem Instrument mittels einer Zentrifugation der Partikel durch den Zykloneffekt in einer geeigneten Einrichtung vom Typ Zyklonfilter (21), wobei die Zentrifugation über den Fluss aktiviert und umgesetzt wird, der durch die Wiederherstellung des Atmosphärendrucks in Bewegung ist,
- Zwischenspeichern der zuvor gestoppten Partikel in situ in einer Sedimentationskammer (26) des Zyklonfilters (21),
- Aufrühren der Restpartikel, die in der Sedimentationskammer (26) zwischengespeichert sind, mittels des durch den Rückfluss verursachten Stroms, der den Zyklonfilter (21) durchquert, wenn der mit den Partikeln befüllte Bereich unter Vakuum gesetzt wird, wobei der Strom in seiner Stärke und seiner Menge ausreichend vorgesehen ist, um die gerade gespeicherten Restpartikel mitzuführen und um sie zu entfernen.

2. Filterverfahren gemäß Anspruch 1, **gekennzeichnet durch** Aufbringen eines plötzlichen Anstiegs des Flusses in mindestens einer der Leitungen und insbesondere in der Leitung (19') des Drucksensors (19) während des Anstiegs des Drucks bis zum Atmosphärendruck in einer Größenordnung von 500 Ncm³/s und eines plötzlichen Anstiegs des Rückflusses während des Herstellens eines Vakuums in der Größenordnung von 88 Ncm³/s.

3. Maschine zum Ausführen des Filterverfahrens gemäß einem der Ansprüche 1 oder 2, wobei die Maschine eingerichtet ist, um die Behandlung der Behälter durch Ablagerung einer Partikelbeschichtung unter Vakuum auf der Wand eines jeden Behälters mittels eines Bildungsprozesses eines Plasmas aus einem Vorläufergas umzusetzen, und sie mindestens eine Messvorrichtung (16, 16') des Typs Drucksensor (19) und/oder Durchflussmesser (17) mit Druckregelung aufweist, wobei die mindestens eine Vorrichtung über eine geeignete Leitung mit dem Behandlungsbereich des Behälters verbunden ist, in dem sich über das Ausstrahlen von Mikrowellen ausgebildete Partikel in Form von Plasma aus einem Vorläufergas, insbesondere Acetylen, bilden, das über einen Injektor (18) in den Behälter eingeleitet wird,
**dadurch gekennzeichnet, dass** sie in der Leitung, die mit dem Behandlungsbereich des Behälters und der mindestens einen Messvorrichtung verbunden ist, eine Filtervorrichtung mit konstantem Druckverlust aufweist, die durch einen Zyklonfilter (21) gebildet wird, der eine Sedimentationskammer (26) zwischen einem tangentialen Zentrifugationsleitungsrohr (23) und einem Rohrstutzen (24) aufweist, wobei der Zyklonfilter - über sein tangentiales Zentrifugationsleitungsrohr (23) an dem Ende der Leitung, die sich bis zu dem Bereich erstreckt, wo die Behandlung der Behälter stattfindet, und - über seinen Rohrstutzen (24) an dem Ende der Leitung, die sich bis zu der Messvorrichtung erstreckt, verbunden ist.

4. Maschine gemäß Anspruch 3, **dadurch gekennzeichnet, dass** sie eine Leitung aufweist, deren Ende stromabwärts vom Zyklonfilter (21) angeordnet ist, dass heißt zwischen letzterem und der Messvorrichtung, und bezüglich des Volumens eine Aufnahmekapazität für Gas und Anderes aufweist, die ausreicht, um einen signifikanten Rückfluss in der Sedimentationskammer des Zyklonfilters herzustellen, um die in der Kammer zurückgehaltenen Restpartikel automatisch aufzurühren und zu entfernen.

5. Maschine gemäß Anspruch 3, **dadurch gekennzeichnet, dass** sie eine Leitung aufweist, deren Ende stromaufwärts vom Zyklonfilter (21) angeordnet ist und zwar zwischen letzterem und dem Behandlungsbereich, und bezüglich des Volumens eine Aufnahmekapazität für Gas aufweist, die unter der des Endes stromabwärts ist, um eine vollständige Übertragung der aufgenommenen Partikel auf der Höhe des Zyklonfilters in Richtung des Behandlungsbereichs an dem stromaufwärtigen Ende vorbei zu ermöglichen.

6. Maschine gemäß Anspruch 3, **dadurch gekennzeichnet, dass** sie eine Messvorrichtung (16') aufweist, die einen Drucksensor (19) darstellt, der über eine Leitung (19') mit dem Anschlussrohr (11) verbunden ist, das einerseits zum Herstellen des Vakuums in dem Behälter und andererseits zum Wiederherstellen des Atmosphärendrucks nach der Behandlung der Behälter dient, wobei die Leitung (19') entlang ihrer Länge einen Zyklonfilter (21) aufweist.

7. Maschine gemäß Anspruch 3, **dadurch gekennzeichnet, dass** sie eine Messvorrichtung (16) aufweist, die einen Durchflussmesser (17) mit Druckregler darstellt, wobei der Durchflussmesser (17) den Injektor (18) über eine geeignete Leitung (17') versorgt, die das Vorläufergas in den zu behandelnden Behälter einleitet, wobei die Leitung (17') entlang ihrer Länge einen Zyklonfilter (21) aufweist.

8. Maschine gemäß Anspruch 3, **dadurch gekennzeichnet, dass** sie mindestens einen Zyklonfilter (21) umfasst, der aufweist:
- einen oberen zylindrischen Körper (22) auf der vertikalen Achse,
- ein in dem oberen Abschnitt des zylindrischen Körpers tangential angeordnetes Leitungsrohr (23), das mit einer Achse fluchtet, die zur Achse des letzteren senkrecht angeordnet ist, wobei das Leitungsrohr (23) mit dem Behandlungsbereich für die Behälter in Verbindung ist und ermöglicht, die Zentrifugation der Restpartikel umzusetzen,
- eine Sedimentationskammer (26) in Form eines umgekehrten Konus, der unter dem zylindrischen Körper (22) angeordnet ist, um die Restpartikel aufzufangen,
- einen Rohrstutzen (24), der im Mittelpunkt des zylindrischen Körpers (22) hinabführt, wobei sich der Rohrstutzen (24) oberhalb des Körpers (22) in Richtung der jeweiligen Messvorrichtung (16, 16') erstreckt.

9. Maschine gemäß Anspruch 8, **dadurch gekennzeichnet, dass** sie einen Zyklonfilter (21) aufweist, dessen Rohrstutzen (24) sich in den zylindrischen Körper (22) erstreckt und zwar bis zu einer Höhe, die in der Größenordnung von 2/3 des Durchmessers des zylindrischen Körpers (22) liegt.

10. Maschine gemäß Anspruch 8, **dadurch gekennzeichnet, dass** sie einen Zyklonfilter (21) aufweist, dessen konischer Abschnitt der Sedimentationskammer (26) sich auf einer Höhe erstreckt, die der wirksamen zylindrischen Wand des zylindrischen Körpers (22) und dem Durchmesser des letzteren entspricht.
